# EUROPEAN PATENT SPECIFICATION

(11) **EP 0 426 174 B1**
(45) Date of publication and mention of the grant of the patent: **27.07.1994**
(21) Application number: 90120945.2
(22) Date of filing: 31.10.1990
(51) Int. Cl.: H01L 27/11

(54) **Semiconductor integrated circuit**
Integrierte Halbleiterschaltung
Circuit intégré semi-conducteur

(30) Priority: 02.11.1989 JP 286505/89; 02.11.1989 JP 286506/89; 02.11.1989 JP 286507/89; 02.11.1989 JP 286508/89
(43) Date of publication of application: 08.05.1991
(73) Proprietor: SEIKO EPSON CORPORATION, Shinjuku-ku Tokyo-to (JP)
(72) Inventor: Itomi, Noboru, Suwa-shi, Nagano-ken (JP)
(74) Representative: Hoffmann, Eckart, Dipl.-Ing.

(56) References cited:
- IEEE ELECTRON DEVICE LETTERS, vol. EDL-4, no. 8, August 1983, NEW YORK US pages 272-274; C. E. CHEN et al.: "STACKED CMOS SRAM CELL"
- PATENT ABSTRACTS OF JAPAN vol. 12, no. 348 (E-659)(3195) 19 September 1988 ; & JP-A-63 104373
- IEEE JOURNAL OF SOLID-STATE CIRCUITS, vol. 24, no. 5, October 1989, New York, US, pp. 1219-1225 ; K. SASAKI et al. : "A 9-ns 1-Mbit CMOS SRAM"
- SYMPOSIUM ON VLSI TECHNOLOGY May 1987, Karuizawa, Japan, pp. 101-102 ; T. YAMANAKA et al. : "A FOLDED RESISTOR AND CAPACITOR (FRC)STATIC MEMORY CELL WITH TRIPLE POLY-SI STRUCTURES"

## Description

The present invention concerns a semiconductor integrated circuit and, more particularly, a semiconductor integrated circuit using a metal insulator semiconductor (MIS) transistor which is fabricated by means of a thin film, or a bistable circuit, for instance a static memory cell, which is composed of MIS transistor which have as their source or drain a doped diffusion layer which is fabricated in a semiconductor substrate. Note that within this description the term "semiconductor substrate" is meant to include a well formed in a semiconductor material.

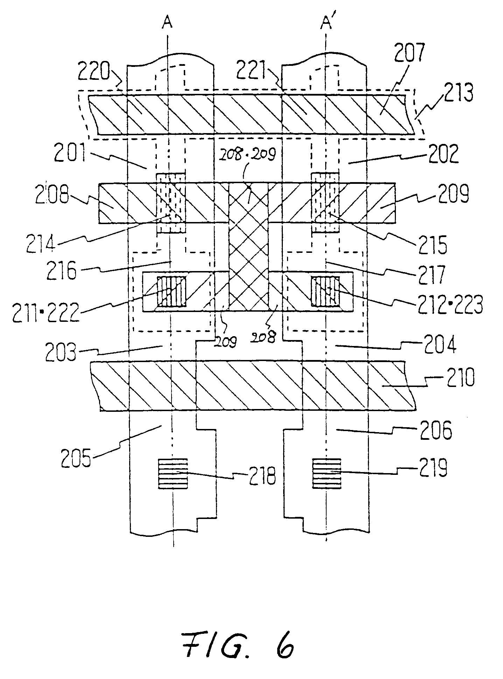

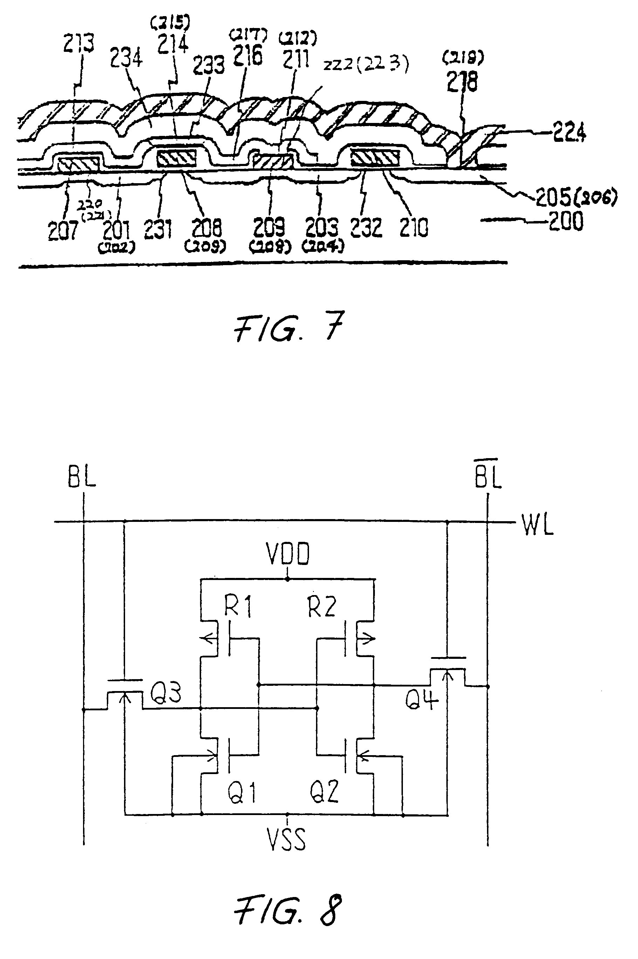

To explain the background of the invention, reference is first made to a prior art complementary MIS static memory cell as an example of an bi-stable circuit. Fig. 6 is a Plan view and Fig. 7 a cross-sectional view along lines A and A′, respectively, in Fig. 6 of the complementary MIS static memory cell (CMIS). In Fig. 7 reference numerals in brackets refer to the section along line A′ in Fig. 6. Fig. 8 is a schematic circuit diagram of the CMIS of Figs. 6 and 7.

In the drawings, 200 is a P-type monocrystalline silicon substrate (as mentioned above, this may be a P-type well formed in an N-type monocrystalline silicon substrate). 201, 202, 203, 204, 205 and 206 are N+ regions formed in the surface portion of the P-type monocrystalline silicon substrate 200. The structure of Figs. 6 and 7 includes three different silicon thin film layers, one formed on the other. 207, 208 and 210 are parts of the first thin film layer of N+ polycrystalline silicon, this first thin film layer being formed through an insulating layer on the surface of the substrate 200. 209 denotes the second thin film layer of N+ polycrystalline silicon formed through an insulating layer on said first thin film layer. 213, 216, 217 sand 214 and 215 are parts of the third thin film layer of P+ and N- polycrystalline silicon, respectively. The third thin film layer is formed through an insulating layer on the second thin film layer. 220, 221 and 223 are buried contacts for electrically connecting the N+ region 201, 202 and 204 to the portions 207 and 208, respectively, of the first thin film layer of N+ polycrystalline silicon. 222 is a buried contact for electrically connecting the N+ region 203 and the portion 209 of the second thin film layer. 211 and 212 are buried contacts for electrically connecting the portion 208 of the first thin film layer and the portion 209 of the second thin film layer to the portions 217 and 216, respectively, of the third thin film layer. 218 and 219 are contact holes for electrically connecting the N+ regions 205 and 206 and an aluminum interconnect layer 224 (not shown in Fig. 6) formed through an insulating layer 234 on the third thin film layer.

231 is a gate insulating layer of a drive N-channel MIS transistor Q1 (Q2), which uses the portion 208 (209) of said first (second) thin film layer as a gate electrode. 232 is a gate insulating film of an N-channel MIS transistor Q3 (Q4) for data transfer, which uses the portion 210 of the first silicon thin film layer as a gate electrode. 233 is a gate insulating layer of a load P-channel MIS transistor R1 (R2), which uses the portion 208 (209) of the first (second) silicon thin film layer as a gate electrode.

The source, drain and gate of the drive N-channel MIS transistors Q1 and Q2 whose channels are formed in the surface portion of the P-type monocrystalline silicon substrate 200 are N+ regions 201 and 203 and the portion 208 of the first silicon thin film layer, respectively, in the case of Q1, and the N+ regions 202 and 204 and the portion 209 of the second silicon thin film layer, respectively, in the case of Q2. The source (or drain), drain (or source) and gate of the transfer N-channel MIS transistors Q3 and Q4 are the N+ regions 203 and 205 and the portion 210 of the first silicon thin film layer, respectively, in the case of Q3, and the N+ regions 204 and 206 and the portion 210 of the first silicon thin film layer, respectively, in the case of Q4. The source, drain and gate of the load P-channel transistors R1 and R2 whose channels are formed in the N- portions 214 and 215 of the third silicon thin film layer are the P+ portions 213 and 216 of the third silicon thin film layer and the portion 208 of the first silicon thin film layer, respectively, in the case of R1 and the portions 213 and 217 of the third layer of P+ polycrystalline silicon thin film and the portion 209 of the second silicon thin film layer, respectively, in case of R2.

In addition, VSS interconnections are formed by the portion 207 of the first silicon thin film layer. VDD interconnections are formed by the P+ portion 213 of the third silicon thin film layer. A word line WL is formed by the portion 210 of the first silicon thin film layer. A bit line pair BL and B̅L̅ is formed by the aluminum interconnect layer 224.

With a static memory cell as explained above, the stability is determined by drive N-channel MIS transistors Q1 and Q2 and transfer N-channel MIS transistors Q3 and Q4. Therefore, in general, in order to have a Q1 and Q3 or Q2 and Q4 beta ratio (the capacity of an MIS transistor based on its channel length (L) and channel width (W)) of 3:1 or better and in order to keep the channel size small, the size of the drive N-channel MIS transistors Q1 and Q2 and the transfer N-channel MIS transistors Q3 and Q4 (i.e. L and W of the MIS transistors) have to be made as small as possible. For this reason, in the prior art the beta value of the drive N-channel MIS transistors Q1 and Q2 has been made small by keeping the beta value of transfer N-channel MIS transistors Q3 and Q4 as small as possible. However, with the prior art technology there is a limit to the decrease of the size of the memory cell because the beta value of transfer N-channel MIS transistors Q3 and Q4 has been determined by the smallest dimension design rule of W.

The document IEEE Electron Device Letters, vol. EDL-4, no. 8, August 1983, pp. 272-274, discloses an SRAM cell comprising two cross-coupled CMOS inverters and two transfer transistors, wherein each CMOS inverter includes a stacked arrangement of a drive transistor and a load transistor sharing the same gate. The channel of the drive transistor is formed in a substrate and that of the load transistor in a polycrystalline silicon layer formed through an insulating layer on top of the drive transistor.

The document Patent Abstracts of Japan, vol. 12, no. 348, September 19, 1988; & JP-A-63 104373, discloses an SRAM cell which like the one described above comprises two cross-coupled inverters and two transfer transistors each having a structure according to the prior art portion of claim 1. In this prior art the transfer transistor is formed on top of the drive transistor and the load resistor is formed adjacent to the stacked arrangement of drive transistor and transfer transistor, thereby occupying additional area of the substrate surface.

It is an object of the present invention to overcome the above mentioned problems of the prior art and to provide a semiconductor integrated circuit of the above mentioned kind, having a smaller size than is possible with the prior art.

This object is achieved with a semiconductor integrated circuit as defined in the claims.

Embodiments of the invention will be described below in detail with reference to drawings, in which:
- Fig. 1: is a plan view of a first embodiment of the present invention,
- Fig. 2: is a cross-sectional view along line A(A′) of Fig.
- Fig. 3: is a schematic circuit diagram of a CMIS memory cell corresponding to the first and second embodiments,
- Fig. 4: is a plan view of a second embodiment of the invention,
- Fig. 5: is a cross-sectional view along line A(A′) of Fig. 4,
- Fig. 6: is a plan view of prior art CMIS static memory cell,
- Fig. 7: is a cross-sectional view along line A(A′) of Fig. 6, and
- Fig. 8: is a schematic circuit diagram of the prior art CMIS memory cell.

### First Embodiment

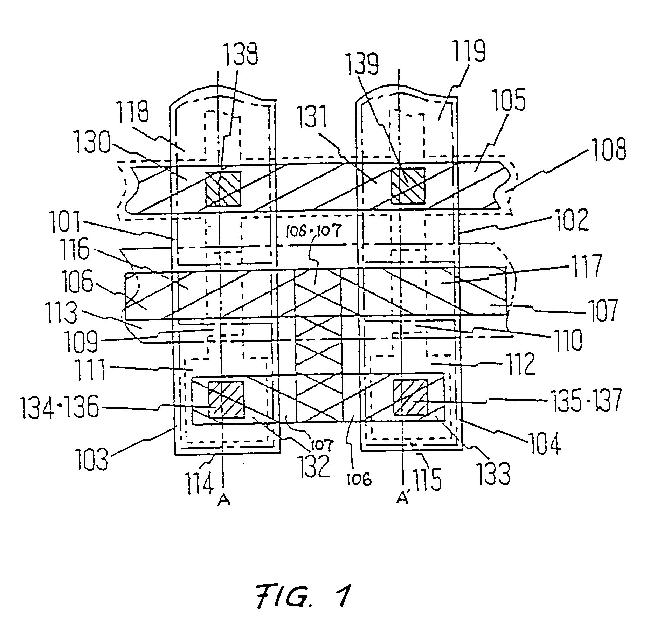

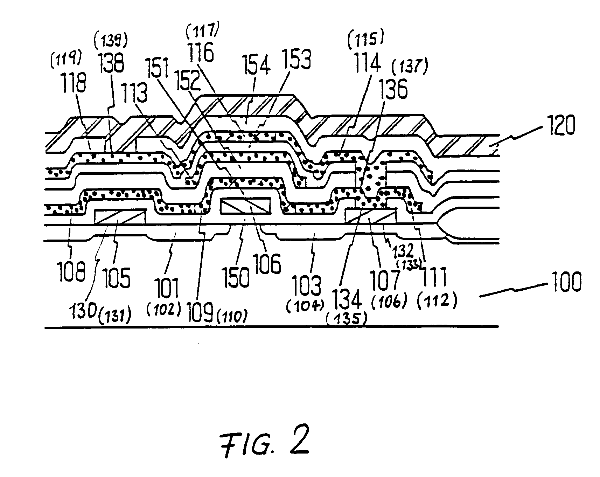

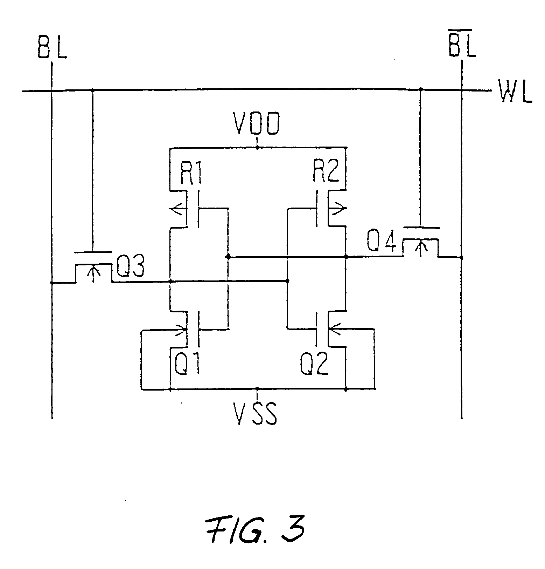

With reference to Figs. 1, 2 and 3 a first embodiment of the invention will be described. Figs. 1 and 2 show a CMIS static memory cell forming a bi-stable circuit of cross-coupled inverters. In Fig. 2 reference numerals in brackets refer to the section along line A′ in Fig. 1. The schematic circuit diagram of the CMIS cell is shown in Fig. 3.

100 is a P- monocrystalline silicon substrate (this substrate may be a P- well formed in an N- monocrystalline silicon substrate). The structure shown in Figs. 1 and 2 comprises five silicon thin film layers one formed on the other with the intermediate of a respective insulating layer. The first thin film layer is of N+ polycrystalline silicon, the second of N+ polycrystalline silicon, the third of P+ and N- polycrystalline silicon, the fourth of N+ polycrystalline silicon and the fifth of N+ and P- polycrystalline silicon.

101, 102, 103 and 104 are N+ regions formed in the surface portion of the substrate 200. 105 and 106 are separate portions of said first silicon thin film layer formed on the surface of the substrate 200 through an insulating layer. 107 are portions of said second silicon thin film layer which is formed through an insulating layer on said first silicon thin film layer. 108, 111, 112 and 109, 110 are P+ and N- portions, respectively, of said third silicon thin film layer formed through an insulating layer on the second silicon thin film layer. 113 is the fourth silicon thin film layer formed through an insulating layer on the third silicon thin film layer. 114, 115, 118, 119 and 116, 117 are N+ and P- portions, respectively, of said fifth silicon thin film layer formed through an insulating layer on the fourth silicon thin film layer. 130 and 131 are buried contacts for electrically connecting the N+ regions 101 and 102, respectively, to the portion 105 of the first silicon thin film layer. 132 is a buried contact for electrically connecting the N+ region 103 and a portion 107 of the second silicon thin film layer. 133 is a buried contact for electrically connecting the N+ region 104 and a portion 106 of the first silicon thin film layer. 134 is a contact hole for electrically connecting a portion 107 of the second silicon thin film layer and P+ portion 111 of the third silicon thin film layer. 135 is a contact hole for electrically connecting a portion 106 of the first silicon thin film layer and P+ portion 112 of the third silicon thin film layer. 136 and 137 are contact holes that are at least in part formed above contact holes 134 and 135 and electrically connect P+ portions 111 and 112 of the third silicon thin film layer and N- portions 114 and 115 of the fifth silicon thin film layer, respectively. 138 and 139 are contact holes for electrically connecting N+ portions 118 and 119 of the fifth silicon thin film layer to an aluminum interconnect layer 120 formed on the fifth silicon thin film layer through an insulating layer 154. The portion 118 (119) of the fifth silicon thin film layer is formed at least in part to overlap (in the plan view) portion 105 of the first silicon thin film layer and portion 108 of the third silicon thin film layer.

150 is a gate insulating layer of drive N-channel MIS transistor Q1 (Q2) which uses portions 106 (107) of the first silicon thin film layer as a gate electrode. 151 is a gate insulating layer of a load P-channel MIS transistor R1 (R2) which uses portion 106 (107) of the first (second) silicon thin film layer as a gate electrode. 152 is an interlayer insulating film between the third an fourth silicon thin film layers. The interlayer insulating film 152 is fabricated of silicon oxide which is thicker than the gate insulating layer 151 of the MIS transistor R1 (R2) and contains almost no impurities. 153 is a gate insulating layer of a transfer N-channel MIS transistor Q3 which uses the fourth silicon thin film layer 113 as a gate electrode. The interlayer insulating film 154 between the fifth silicon thin film layer and the aluminum interconnect layer 120 is made of silicon oxide, is thicker than the gate insulating layer 153 and contains almost no impurities, that means not more impurities than the gate insulating layer. Portions 106 and 107 of the first and second silicon thin film layers are stacked between insulating layers as to be seen in Fig. 2.

The source, drain and gate of the drive N-channel MIS transistors Q1 and Q2 whose channels are formed in the surface portion of the substrate 100 are N+ regions 101, 103 and portion 106 of the first silicon thin film layer, respectively, in the case of Q1, and N+ regions 102, 104 and portion 107 of the second silicon thin film layer, respectively, in the case of Q2. The source, drain and gate of the load P-channel MIS transistors R1 and R2 whose channels are formed in the N- portions 109 and 110 of the third silicon thin film layer are the P+ portions 108 and 111 of the third silicon thin film layer and portion 106 of the first silicon thin film layer, respectively, in the case of R1, and the P+ portions 108 and 112 of the third silicon thin film layer and portion 107 of the second silicon thin film layer, respectively, in the case of R2. The source (or drain), drain (or source) and gate of the transfer N-channel transistors Q3 and Q4 whose channels are formed in the P- portions 116 and 117 of the fifth silicon thin film layer are N+ portions 114 and 118 of the fifth silicon thin film layer and the fourth silicon thin film layer 113, respectively, in the case of Q3, and the N+ portions 115 and 119 of the fifth silicon thin film layer and the fourth silicon thin film layer 113, respectively, in the case of Q4.

The interconnection for the low power supply potential VSS is formed by portion 105 of the first silicon thin film layer. The interconnection for the high power supply potential VDD is formed parallel to the VSS interconnection (105) by the P+ portion 108 of the third silicon thin film layer which is fabricated as a unit with the source of the load P-channel MIS transistors R1 and R2. The word line WL interconnection is formed parallel to the VSS interconnection (105) by the fourth silicon thin film layer 113 as a unit with the gate electrode of the transfer N-channel MIS transistors Q3 and Q4. The interconnection of the bit line pair BL and B̅L̅ is fabricated orthogonally to the VSS interconnection (105) and the word line (113) by the aluminum interconnection layer 120.

With the aforementioned first embodiment of the invention, the channels of the transfer N-channel MIS transistors Q3 and Q4 are not formed in the surface portion of the substrate 100. By using for these channels the P- portions 116 and 117 of the fifth silicon thin film layer which is formed on the drive N-channel MIS transistors Q1 and Q2 or on the load P-channel MIS transistors R1 and R2, the degree of mobility of carriers of the transistors will be lower than in the case that the channels are formed in the substrate 100. Since in this case W may be increased, the beta required for the transistor can be obtained.

In addition, because the transfer N-channel MIS transistors Q3 and Q4 do not use the substrate 100 for their channel as the N-channel MIS transistors Q1 and Q2 do, no additional surface area is required for the transfer transistors Q3 and Q4. Moreover, with the fourth silicon thin film layer 113 as the gate electrode of transfer MIS transistor Q3, the threshold voltage of parasitic MIS transistors can be made such that these transistors are presented from being operated, and the leak current can be reduced between the source and drain of the load MIS transistor and the transfer MIS transistor by increasing the thickness of the interlayer insulating films 152 and 154 which are the gate insulating layers. One of those parasitic MIS transistors is formed by the P+ portion 108, the N- portion 109 and the P+ portion 111 of the third silicon thin film layer, which are the source, channel and drain of load MIS transistor R1 and the aluminum interconnect layer 120 which is the bit line BL as the gate electrode. Another parasitic MIS transistor is formed by the N+ portion 118, the P- portion 116 (as channel) and the N+ portion 114 of the fifth silicon thin film layer, which are the source (or drain), channel and the drain (or source) of the transfer MIS transistor Q3 and layer 120 as gate.

By using silicon oxide that contains almost no impurities for the interlayer insulating films 152 and 154, the leak current between the source and drain of the load MIS transistor and the transfer MIS transistor can be reduced by not fabricating an N region or by not fabricating a P region on the N- portion 109 of the third silicon thin film layer and the P- portion 116 of the fifth silicon thin film layer.

### Second Embodiment

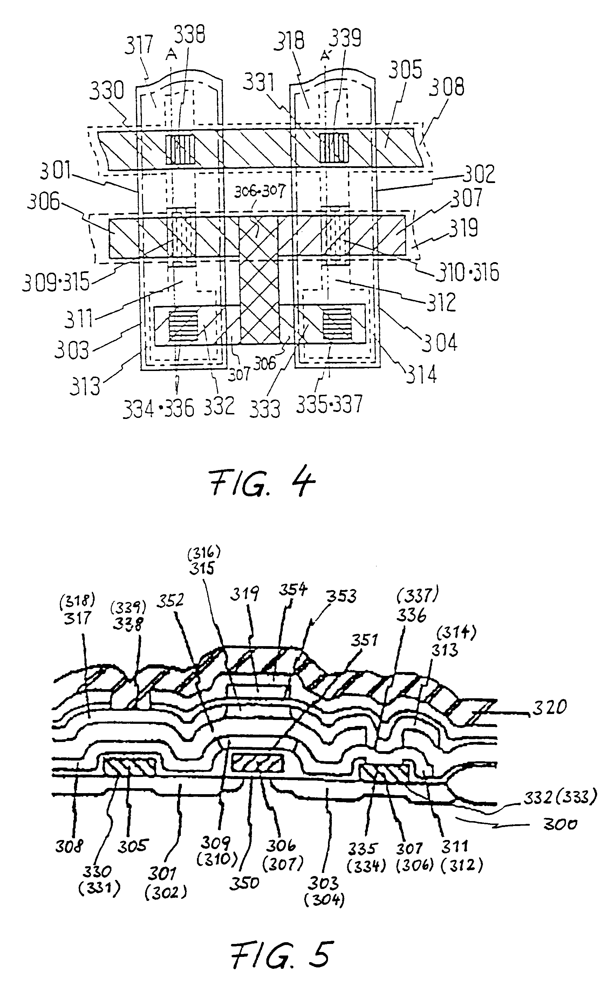

A second embodiment will be explained below with reference to Figs. 4, 5 and 3. Fig. 4 is plan view and Fig. 5 a cross-sectional view along line A(A′) of Fig. 4. Fig. 3 is a schematic circuit diagram of the CMIS static memory cell of this embodiment. In Fig. 5 reference numerals in brackets refer to the section along line A′ in Fig. 4.

In the second embodiment, 300 is a P- monocrystalline silicon substrate and may be a P- well formed in an N- monocrystalline silicon substrate. Like the first embodiment, the second embodiment employs a structure of five silicon thin film layers, formed one on the other with the intermediate of a respective insulating layer. The first layer of N+ polycrystalline silicon is formed on the surface of the substrate 300 through an insulating layer. The second layer of N+ polycrystalline silicon is formed on the first layer through an insulating layer. The third layer of P+ and N- polycrystalline silicon is formed on the second layer through an insulating layer. The fourth layer of N+ and P- polycrystalline silicon is formed on the third layer through an insulating layer. The fifth layer of N+ polycrystalline silicon is formed on the fourth layer through an insulating layer.

301, 302, 303 and 304 are N+ regions formed in the surface portion of the substrate 300. 305 and 306 are portions of the first silicon thin film layer. 307 are portions of the second silicon thin film layer. 308, 311, 312 and 309, 310 are P+ portions and N- portions, respectively, of the third silicon thin film layer. 313, 314, 317, 318 and 315, 316 are N+ portions and P- portions, respectively, of the fourth silicon thin film layer. 319 is the fifth silicon thin film layer.

330 and 331 are buried contacts for electrically connecting N+ regions 301 and 302 to portion 305 of the first silicon thin film layer. 332 is a buried contact for electrically connecting the N+ region 303 and portion 307 of the second silicon thin film layer. 333 is a buried contact for electrically connecting the N+ region 304 and portion 306 of the first silicon thin film layer. 334 is a contact hole for electrically connecting portion 307 of the second silicon thin film layer and P+ portion 311 of the third silicon thin film layer. 335 is a contact hole for electrically connecting portion 307 of the first silicon thin film layer and P+ portion 312 of the third silicon thin film layer.

336 and 337 are contact holes that are formed at least in part above contact holes 334 and 335 in order to electrically connect P+ portions 311 and 312 of the third silicon thin film layer to N+ portions 313 and 314, respectively, of the fourth silicon thin film layer. 338 and 339 are contact holes for the purpose of electrically connecting portions 317 and 318 of the fourth silicon thin film layer to an aluminum interconnect layer 320. The portion 317 (318) of the fourth silicon thin film layer is at least in part formed to overlap (in plan view) portion 305 of the first silicon thin film layer and portion 308 of the third silicon thin film layer (not shown in Fig. 4). Layer 320 is fabricated on the fifth silicon thin film layer through an insulating layer 354.

350 is a gate insulating layer of a drive N-channel MIS transistor Q1 (Q2), which uses portion 306 (307) of the first (second) silicon thin film layer as the gate electrode. 351 is a gate insulating layer of a load P-channel MIS transistor R1 (R2), which uses the portion 306 (307) of the first (second) silicon thin film layer as the gate electrode. 352 is an interlayer insulating film between the third and fourth silicon thin film layers. The interlayer insulating film 352 is thicker than the gate insulating layer 351 and formed of silicon oxide which contains almost no impurities. 353 is a gate insulating layer of a transfer MIS transistor Q3 (Q4) which uses the fifth silicon thin film layer 319 as the gate electrode. The portions 306 and 307 of the first and second silicon thin film layer, respectively, are stacked between the interlayer insulating films.

The source, drain and gate of the drive N-channel MIS transistors Q1 and Q2 are N+ regions 301, 303 and portion 306 of the first silicon thin film layer, respectively, in the case of Q1, and N+ regions 302, 304 and portion 307 of the second silicon thin film layer, respectively, in the case of Q2. The substrate 300 is used for the channel portions of these transistors. The source, drain and gate of the load P-channel MIS transistors R1 and R2 are P+ portions 308, 311 of the third silicon thin film layer and portion 306 of the first silicon thin film layer, respectively, in the case of R1, and P+ portions 308 and 312 of the third silicon thin film layer and portion 307 of the second silicon thin film layer, respectively, in the case of R2. The N- portions 309 and 310 of the third silicon thin film layer are used for the channels of transistors R1 and R2, respectively. The source (or drain), drain (or source) and gate of the transfer N-channel transistors Q3 and Q4 are N+ regions 313 and 317 of the fourth silicon thin film layer and the fifth silicon thin film layer 319, respectively, in the case of Q3, and N+ portions 314 and 318 of the fourth silicon thin film layer and the fifth silicon thin film layer 319, respectively, in the case of Q4. P- portions 315 and 316 are used for the channels of Q3 and Q4, respectively.

The interconnection for the low power supply electrical potential VSS is the portion 305 of the first silicon thin film layer. The interconnection for the high power supply electrical potential VDD is P+ portion 308 of the third silicon thin film layer, which is formed in parallel to the VSS interconnection and forms the source of the load MIS transistors R1 and R2 at the same time. The interconnection for the word line WL is the the fifth silicon thin film layer 319, which is formed in parallel to the VSS interconnection and provides the gate electrodes of the N-channel MIS transistors Q3 and Q4 at the same time. The interconnection of the data bit line pair BL and B̅L̅ is formed orthogonally to the VSS interconnection and the word line WL by the aluminum interconnection layer connected to the contact holes 338 and 339.

With the aforementioned second embodiment of the invention, the channels of the transfer N-channel MIS transistors Q3 and Q4 are not formed in the surface portion of the substrate 300. By using for these channels the P- portions 315 and 316 of the fourth silicon thin film layer which is formed on the drive N-channel MIS transistors Q1 and Q2 or on the load P-channel MIS transistors R1 and R2, the degree of mobility of carriers of the transistors will be lower than in the case that the channels are formed in the substrate 300. Since in this case W may be increased, the beta required for the transistor can be obtained.

In addition, because the transfer N-channel MIS transistors Q3 and Q4 do not use the substrate 300 for their channel as the N-channel MIS transistors Q1 and Q2 do, no additional surface area is required for the transfer transistors Q3 and Q4. Moreover, by having the channel portions of load MIS transistors R1 and R2 and the channel portions of transfer MIS transistors Q3 and Q4 opposed each other by means of an interlayer insulating layer that is thicker than the gate insulating layer 351 of the load MIS transistors RI and R2 and the gate insulating layer 353 of the transfer MIS transistors Q3 and Q4, the leak current between the source and drain of the load MIS transistors and the transfer MIS transistors can be reduced better than with a configuration in which the gate electrode (319) is formed on the third silicon thin film layer through an insulating layer.

By using silicon oxide that contains almost no impurities (at least not more than the gate insulating layer) for the interlayer insulating film 352, the leak current between the source and drain of the load MIS transistor and the transfer MIS transistor can be reduced by not fabricating an N region or by not fabricating a P region on the N-portions 309 and 310 of the third silicon thin film layer and the P- portions 315 and 316 of the fourth silicon thin film layer, which are the channels of the load MIS transistor and the transfer MIS transistor.

For the above first and second embodiments the thin films for the first, second and third layers have been described to be of N+ polycrystalline silicon. As an alternative polycide thin film layers may be used instead. Instead of P+ and N- polycrystalline silicon used for the third thin film layer P+ and N- monocrystalline silicon thin film layers could be used. Alternatively, the channels may be made of a layer of monocrystalline silicon and the source and drain may be made of a thin film layer either of monocrystalline silicon or polycrystalline silicon. Similarly, instead of using N+ and P- polycrystalline silicon for the fifth thin film layer in the first embodiment or the fourth thin film layer in the second embodiment, a thin film layer of N+ and P- monocrystalline silicon may be used. Alternatively, the channels may be made of monocrystalline silicon and source and drain of a thin film layer of either monocrystalline silicon or polycrystalline silicon. In addition, the channels of the load or the transfer MIS transistors may be fabricated of an undoped intrinsic silicon and the source and drain may be fabricated of an non-intrinsic silicon. In the described embodiments of the invention, an N-channel MIS transistor is used for the transfer MIS transistors Q3 and Q4. However, it goes without saying that the same effect can be obtained by using a P-channel MIS transistor. Also, the interlayer insulating films may either be a one layer or a multi layer structure, provided that the portions that contacts at least a part of the channels of the load MIS transistors and the transfer MIS transistors is an insulating layer that contains almost no impurities.

As described above, by forming the transfer MIS transistors Q3 and Q4 on the drive MIS transistors Q1 and Q2 or load MIS transistors R1 and R2 through an insulating layer, no surface area for the transfer MIS transistors Q3 and Q4 is required, allowing a substantial reduction in the size of the chip. Also, by making the interlayer insulating film that contacts the channel portions of the load MIS transistors and the transfer MIS transistors, an insulating layer that contains almost no impurities and by making it thicker than gate insulating layer, the threshold voltage of parasitic transistors can be made high enough to prevent them from being operated, and the leak current between the source and the drain can be reduced.

Furthermore, by having the channel portions of the load MIS transistors and the transfer MIS transistors oppose each other, the source, drain and channel portions of the transfer MIS transistors can be formed through the self-alignment technique with the gate electrode as a mask.

## Claims

1. A semiconductor integrated circuit comprising an inverter having a drive MIS transistor (Q1, Q2), a load device (R1, R2) and a transfer MIS transistor (Q3, Q4) transferring the output of the inverter (Q1, R1; Q2, R2) to a data line (BL, B̅L̅), the channel of the drive MIS transistor being formed in a surface portion of a semiconductor substrate (100; 300), the load device being formed of a first silicon layer (108-112; 308-312) provided through an insulating layer on said semiconductor substrate and the channel of the transfer MIS transistor being formed of a part of a silicon layer (114-119; 313-318) provided through an insulating layer (152; 352) above said drive MIS transistor, characterized in that the channel of the transfer MIS transistor is formed of a part of a second silicon layer (114-119; 313-318) provided through an insulating layer (152; 352) on top of the load device, wherein one of two regions of said second silicon layer is electrically connected to the output of said inverter while the other region is connected to said data line (BL, B̅L̅) and at least a portion of a contact between the transfer MIS transistor (Q3, Q4) and said data line (BL, B̅L̅) is formed over a VDD power source interconnection or a VSS power source interconnection.

2. The semiconductor integrated circuit according to claim 1, characterized in that the gate electrode of the transfer MIS transistor is formed by a first interconnect layer (113) which is located between an insulating layer (152) and a gate insulation layer (153) between said first and second silicon layers.

3. The semiconductor integrated circuit according to claim 2, characterized in that the insulating layer (152) between the first interconnect layer (113) and the first silicon layer (108-112) is thicker than the gate insulating layer (153) between the first interconnect layer and the second silicon layer (114-119).

4. The semiconductor integrated circuit according to claim 2 or 3, characterized in that the insulating layer (152) between said first interconnect layer (113) and the first silicon layer is made of silicon oxide which is almost free of impurities.

5. The semiconductor integrated circuit according to claim 1, characterized in that the gate electrode of the transfer MIS transistor (Q3, Q4) is formed by a first interconnect layer (319) which is located on said second silicon layer (313-318) through a gate insulating layer (353).

6. The semiconductor integrated circuit according to claim 5, characterized in that said insulating layer (352) between the first silicon layer (308-312) and the second silicon layer (313-318) is thicker than the gate insulating layer (353) between said first interconnect layer (319) and the second silicon layer.

7. The semiconductor integrated circuit according to any of the preceding claims, characterized in that said first layer of silicon (108-112; 308-312) is formed through a gate insulating layer (151; 351) on the gate electrode (106, 107; 306, 307) of said drive MIS transistor (Q1, Q2).

8. The semiconductor integrated circuit according to claim 7, characterized in that said load device is composed of a load MIS transistor, having as its channel a local region (109, 110; 309, 310) of said first layer of silicon which is located on the gate electrode of the drive MIS transistor.

9. The semiconductor integrated circuit according to claim 8, characterized in that the load MIS transistor and the drive MIS transistor share the same gate electrode (106, 107; 306, 307).

10. The semiconductor integrated circuit according to claim 9, characterized in that the insulating layer (151; 351) between the gate electrode (106, 107; 306, 307) of said drive MIS transistor (Q1, Q2) and said load MIS transistor (R1, R2) is thinner than the insulating layer (152; 352) between the first layer of silicon and the second layer of silicon.

11. The semiconductor integrated circuit according to claim 9, characterized in that the gate electrode of the transfer MIS transistor (Q3, Q4) is formed by a third silicon layer (113) located between said first and second layers of silicon, an insulating layer (152) between the first and third layers of silicon being thicker than the gate insulating layer (151) between the first layer of silicon and the gate electrode (106, 107) of said drive and load MIS transistors and thicker than the gate insulating layer (153) between the second and third layers of silicon.

12. The semiconductor integrated circuit according to any of the preceding claims, characterized in that the insulating layer (152; 352) between the first and second layers of silicon (108-112, 114-119; 308-312, 313-318) is formed of silicon oxide that contains almost no impurities.

13. The semiconductor integrated circuit according to claim 11, characterized in that the insulating layer (152) between the first and third layers of silicon is formed of silicon oxide that contains almost no impurities.

14. The semiconductor integrated circuit according to claim 8, characterized in that the first silicon layer has a local region (108; 308), which forms the drain of the load MIS transistor (R1, R2), and is electrically connected to a drain diffusion region (101, 102; 301, 302) of the drive MIS transistor (Q1, Q2) through a first contact hole (134, 135; 334, 335), and that the second layer of silicon has a local region (114, 115, 313, 314) which forms a drain or source of the transfer MIS transistor (Q3, Q4) and is electrically connected to the first layer of silicon through a second contact hole (136, 137; 336, 337).

15. The semiconductor integrated circuit according to any of the preceding claims, characterized in that said data line (BL, B̅L̅) is in contact with the second layer of silicon, and a third contact hole (138, 139; 338, 339) is formed above a part of a source diffusion region of the drive MIS transistor.

16. The semiconductor integrated circuit according to claim 15, characterized in that said third contact hole (138, 139; 338, 339) is formed above a part of the first layer of silicon (118, 119; 317, 318).

17. The semiconductor integrated circuit according to any of claims 8 to 16, characterized in that the drive MIS transistor is of N type and the load MIS transistor of P type.

18. The semiconductor integrated circuit according to any of the preceding claims, characterized by a second inverter formed in the same way as said first inverter in a region adjacent to the first inverter, a bi-stable circuit being composed of the two inverters.

19. The semiconductor integrated circuit according to claim 18, characterized in that the bi-stable circuit forms a memory cell of an SRAM.

20. A semiconductor integrated circuit according to claim 19, characterized in that an interconnection of the data line pair (BL B̅L̅) is formed on the transfer MIS transistors (Q3, Q4) through an insulating layer (154, 354), of which at least that part that contacts the channels of the transfer MIS transistors (Q3, Q4) is made thicker than the gate insulating layer (153, 353) of the transfer MIS transistors (Q3, Q4).

21. The semiconductor integrated circuit according to claims 8 and 20, characterized in that said insulating layers which contact at least a portion of the channels of either the load MIS transistors (R1, R2) or the transfer MIS transistors (Q3, Q4) are formed of silicon oxide that is almost free of impurities.

22. The semiconductor integrated circuit according to any of claims 19 to 21, characterized in that the drive MIS transistors (Q1, Q2) and the transfer MIS transistors (Q3, Q4) are of a first conductivity type and the load MIS transistors (R1, R2) are of a second conductivity type different from the first conductivity type.

23. The semiconductor integrated circuit according to any of claims 19 to 21, characterized in that the drive MIS transistors (Q1, Q2) are of a first conductivity type and the transfer MIS transistors (Q3, Q4) and the load MIS transistors (R1, R2) are of a second conductivity type different from the first conductivity type.

24. The semiconductor integrated circuit according to claim 22 or 23, characterized in that said first conductivity type is N and said second conductivity type is P.

25. The semiconductor integrated circuit according to any of the preceding claims, characterized in that the semiconductor substrate (300) is a monocrystalline silicon substrate and the layers of semiconductor thin film are polycrystalline or monocrystalline silicon thin film layers.

## Patentansprüche

1. Integrierte Halbleiterschaltung, umfassend einen Inverter mit einem Treiber-MIS-Transistor (Q1, Q2), einer Lasteinrichtung (R1, R2) und einem Übertragungs-MIS-Transistor (Q3, Q4), der das Ausgangssignal des Inverters (Q1, R1; Q2, R2) an eine Datenleitung (BL, B̅L̅) überträgt, wobei der Kanal des Treiber-MIS-Transistors in einem Oberflächenabschnitt eines Halbleitersubstrats (100; 300) ausgebildet ist, die Lasteinrichtung von einer ersten Siliziumschicht (108-112; 308-312) gebildet wird, die vermittels einer Isolierschicht auf dem Halbleitersubstrat ausgebildet ist, und der Kanal des Übertragungs-MIS-Transistors von einem Teil einer Siliziumschicht (114-119; 313-318) gebildet wird, die vermittels einer Isolierschicht (152; 352) über dem Treiber-MIS-Transistor vorgesehen ist, dadurch gekennzeichnet, daß der Kanal des Übertragungs-MIS-Transistors als Teil einer zweiten Siliziumschicht (114-119; 313-318) ausgebildet ist, die vermittels einer Isolierschicht (152; 352) oben auf der Lasteinrichtung vorgesehen ist, wobei eine von zwei Zonen der zweiten Siliziumschicht elektrisch mit dem Ausgang des Inverters verbunden ist, während die andere Zone mit der Datenleitung (BL, B̅L̅) verbunden ist und wenigstens ein Abschnitt eines Kontakts zwischen dem Übertragungs-MIS-Transistor (Q3, Q4) und der Datenleitung (BL, B̅L̅) über einer VDD-Stromversorgungs-Zwischenverbindung oder einer VSS-Stromversorgungs-Zwischenverbindung ausgebildet ist.

2. Integrierte Halbleiterschaltung nach Anspruch 1, dadurch gekennzeichnet, daß die Gateelektrode des Übertragungs-MIS-Transistors von einer ersten Zwischenverbindungsschicht (113) gebildet wird, die zwischen einer Isolierschicht (152) und einer Gateisolierschicht (153) zwischen der ersten und der zweiten Siliziumschicht angeordnet ist.

3. Integrierte Halbleiterschaltung nach Anspruch 2, dadurch gekennzeichnet, daß die Isolierschicht (152) zwischen der ersten Zwischenverbindungsschicht (113) und der ersten Siliziumschicht (108-112) dicker ist als die Gateisolierschicht (153) zwischen der ersten Zwischenverbindungsschicht und der zweiten Siliziumschicht (114-119).

4. Integrierte Halbleiterschaltung nach Anspruch 2 oder 3, dadurch gekennzeichnet, daß die Isolierschicht (152) zwischen der ersten Zwischenverbindungsschicht (113) und der ersten Siliziumschicht aus einem Siliziumoxid hergestellt ist, das nahezu frei von Störstellen ist.

5. Integrierte Halbleiterschaltung nach Anspruch 1, dadurch gekennzeichnet, daß die Gateelektrode des Übertragungs-MIS-Transistors (Q3, Q4) von einer ersten Zwischenverbindungsschicht (319) gebildet ist, die vermittels einer Gateisolierschicht (353) auf der zweiten Siliziumschicht (313-318) angeordnet ist.

6. Integrierte Halbleiterschaltung nach Anspruch 5, dadurch gekennzeichnet, daß die Isolierschicht (352) zwischen der ersten Siliziumschicht (308-312) und der zweiten Siliziumschicht (313-318) dicker ist als die Gateisolierschicht (353) zwischen der ersten Zwischenverbindungsschicht (319) und der zweiten Siliziumschicht.

7. Integrierte Halbleiterschaltung nach einem der vorhergehenden Ansprüche, dadurch gekennzeichnet, daß die erste Schicht aus Silizium (108-112; 308-312) vermittels einer Gateisolierschicht (151; 351) auf der Gateelektrode (106, 107; 306, 307) des Treiber-MIS-Transistors (Q1, Q2) ausgebildet ist.

8. Integrierte Halbleiterschaltung nach Anspruch 7, dadurch gekennzeichnet, daß die Lasteinrichtung sich aus einem Last-MIS-Transistor zusammensetzt, der als seinen Kanal eine lokale Zone (109, 110; 309, 310) der ersten Schicht aus Silizium aufweist, die auf der Gateelektrode des Treiber-MIS-Transistors angeordnet ist.

9. Integrierte Halbleiterschaltung nach Anspruch 8, dadurch gekennzeichnet, daß der Last-MIS-Transistor und der Treiber-MIS-Transistor sich dieselbe Gateelektrode (106, 107; 306, 307) teilen.

10. Integrierte Halbleiterschaltung nach Anspruch 9, dadurch gekennzeichnet, daß die Isolierschicht (151; 351) zwischen der Gateelektrode (106, 107; 306, 307) des Treiber-MIS-Transistors (Q1, Q2) und dem Last-MIS-Transistor (R1, R2) dünner ist als die Isolierschicht (152; 352) zwischen der ersten Schicht aus Silizium und der zweiten Schicht aus Silizium.

11. Integrierte Halbleiterschaltung nach Anspruch 9, dadurch gekennzeichnet, daß die Gateelektrode des Übertragungs-MIS-Transistors (Q3, Q4) von einer dritten Siliziumschicht (113) gebildet wird, die zwischen der ersten und der zweiten Schicht aus Silizium angeordnet ist, wobei eine Isolierschicht (152) zwischen der ersten und der dritten Schicht aus Silizium dicker ist als die Gateisolierschicht (151) zwischen der ersten Schicht aus Silizium und der Gateelektrode (106, 107) des Treiber- und des Last-MIS-Transistors und dicker ist als die Gateisolierschicht (153) zwischen der zweiten und der dritten Schicht aus Silizium.

12. Integrierte Halbleiterschaltung nach einem der vorhergehenden Ansprüche, dadurch gekennzeichnet, daß die Isolierschicht (152; 352) zwischen der ersten und der zweiten Schicht aus Silizium (108-112, 114-119; 308-312, 313-318) aus Siliziumoxid gebildet ist, das nahezu keine Störstellen enthält.

13. Integrierte Halbleiterschaltung nach Anspruch 11, dadurch gekennzeichnet, daß die Isolierschicht (152) zwischen der ersten und der dritten Schicht aus Silizium aus Siliziumoxid gebildet ist, das nahezu keine Störstellen enthält.

14. Integrierte Halbleiterschaltung nach Anspruch 8, dadurch gekennzeichnet, daß die erste Siliziumschicht eine lokale Zone (108; 308) aufweist, die die Drain des Last-MIS-Transistors (R1, R2) bildet und elektrisch mit einer Draindiffusionszone (101, 102; 301, 302) des Treiber-MIS-Transistors (Q1, Q2) über ein erstes Kontaktloch (134, 135; 334, 335) verbunden ist, und daß die zweite Schicht aus Silizium eine lokale Zone (114, 115; 313, 314) aufweist, die eine Drain oder Source des Übertragungs-MIS-Transistors (Q3, Q4) bildet und elektrisch mit der ersten Schicht aus Silizium über ein zweites Kontaktloch (136, 137; 336, 337) verbunden ist.

15. Integrierte Halbleiterschaltung nach einem der vorhergehenden Ansprüche, dadurch gekennzeichnet, daß die Datenleitung (BL, B̅L̅) mit der zweiten Schicht aus Silizium in Kontakt steht und ein drittes Kontaktloch (138, 139; 338, 339) über einem Teil einer Sourcediffusionszone des Treiber-MIS-Transistors ausgebildet ist.

16. Integrierte Halbleiterschaltung nach Anspruch 15, dadurch gekennzeichnet, daß das dritte Kontaktloch (138, 139; 338, 339) über einem Teil der ersten Schicht aus Silizium (118, 119; 317, 318) ausgebildet ist.

17. Integrierte Halbleiterschaltung nach einem der Ansprüche 8 bis 16, dadurch gekennzeichnet, daß der Treiber-MIS-Transistor vom N-Typ ist und der Last-MIS-Transistor vom P-Typ ist.

18. Integrierte Halbleiterschaltung nach einem der vorhergehenden Ansprüche, gekennzeichnet durch einen zweiten Inverter, der in gleicher Weise wie der erste Inverter in einer Zone angrenzend an den ersten Inverter ausgebildet ist, wobei die beiden Inverter eine bistabile Schaltung bilden.

19. Integrierte Halbleiterschaltung nach Anspruch 18, dadurch gekennzeichnet, daß die bistabile Schaltung eine Speicherzelle eines SRAM bildet.

20. Integrierte Halbleiterschaltung nach Anspruch 19, dadurch gekennzeichnet, daß eine Zwischenverbindung des Datenleitungspaars (BL, B̅L̅) auf den Übertragungs-MIS-Transistoren (Q3, Q4) vermittels einer Isolierschicht (154, 354) ausgebildet ist, von der wenigstens der Teil, der die Kanäle der Übertragungs-MIS-Transistoren (Q3, Q4) kontaktiert, dicker ausgebildet ist als die Gateisolierschicht (153, 353) der Übertragungs-MIS-Transistoren (Q3, Q4).

21. Integrierte Halbleiterschaltung nach den Ansprüchen 8 und 20, dadurch gekennzeichnet, daß die Isolierschichten, die wenigstens einen Teil der Kanäle entweder der Last-MIS-Transistoren (R1, R2) oder der Übertragungs-MIS-Transistoren (Q3, Q4) kontaktieren, aus Siliziumoxid gebildet sind, das nahezu frei von Störstellen ist.

22. Integrierte Halbleiterschaltung nach einem der Ansprüche 19 bis 21, dadurch gekennzeichnet, daß die Treiber-MIS-Transistoren (Q1, Q2) und die Übertragungs-MIS-Transistoren (Q3, Q4) von einem ersten Leitungstyp und die Last-MIS-Transistoren (R1, R2) von einem zweiten Leitungstyp sind, der von dem ersten Leitungstyp verschieden ist.

23. Integrierte Halbleiterschaltung nach einem der Ansprüche 19 bis 21, dadurch gekennzeichnet, daß die Treiber-MIS-Transistoren (Q1, Q2) von einem ersten Leitungstyp und die Übertragungs-MIS-Transistoren (Q3, Q4) und die Last-MIS-Transistoren (R1, R2) von einem zweiten Leitungstyp sind, der von dem ersten Leitungstyp verschieden ist.

24. Integrierte Halbleiterschaltung nach Anspruch 22 oder 23, dadurch gekennzeichnet, daß der erste Leitungstyp N und der zweite Leitungstyp P ist.

25. Integrierte Halbleiterschaltung nach einem der vorhergehenden Ansprüche, dadurch gekennzeichnet, daß das Halbleitersubstrat (300) ein einkristallines Siliziumsubstrat ist und die Schichten aus einem Halbleiterdünnfilm polykristalline oder einkristalline Silizium-Dünnfilmschichten sind.

## Revendications

1. Un circuit intégré à semiconducteurs comprenant un inverseur ayant un transistor MIS d'attaque (Q1, Q2), un dispositif de charge (R1, R2) et un transistor MIS de transfert (Q3, Q4) qui transfère le signal de sortie de l'inverseur (Q1, R1 ; Q2, R2) vers une ligne de données (BL, B̅L̅), le canal du transistor MIS d'attaque étant formé dans une partie de surface d'un substrat semiconducteur (100 ; 300), le dispositif de charge étant formé par une première couche de silicium (108-112 ; 308-312) disposée sur le substrat semiconducteur avec interposition d'une couche isolante, et le canal du transistor MIS de transfert étant formé par une partie d'une couche de silicium (114-119 ; 313-318) disposée au-dessus du transistor MIS d'attaque, avec interposition d'une couche isolante (152 ; 352), caractérisé en ce que le canal du transistor MIS de transfert est formé par une partie d'une seconde couche de silicium (144-119 ; 313-318) qui est disposée sur le dispositif de charge, avec interposition d'une couche isolante (152 ; 352), l'une de deux régions de la seconde couche de silicium étant connectée électriquement à la sortie de l'inverseur, tandis que l'autre région est connectée à la ligne de données (BL, B̅L̅) et au moins une partie d'un contact entre le transistor MIS de transfert (Q3, Q4) et la ligne de données (BL, B̅L̅) étant formée sur une interconnexion de source d'alimentation VDD ou sur une interconnexion de source d'alimentation VSS.

2. Le circuit intégré à semiconducteurs selon la revendication 1, caractérisé en ce que l'électrode de grille du transistor MIS de transfert est formée par une première couche d'interconnexion (113) qui se trouve entre une couche isolante (152) et une couche d'isolation de grille (153), entre les première et seconde couches de silicium.

3. Le circuit intégré à semiconducteurs selon la revendication 2, caractérisé en ce que la couche isolante (152) entre la première couche d'interconnexion (113) et la première couche de silicium (108-112) est plus épaisse que la couche d'isolation de grille (153) entre la première couche d'interconnexion et la seconde couche de silicium (114-119).

4. Le circuit intégré à semiconducteurs selon la revendication 2 ou 3, caractérisé en ce que la couche isolante (152) entre la première couche d'interconnexion (113) et la première couche de silicium consiste en oxyde de silicium qui est presque exempt d'impuretés.

5. Le circuit intégré à semiconducteurs selon la revendication 1, caractérisé en ce que l'électrode de grille du transistor MIS de transfert (Q3, Q4) est formée par une première couche d'interconnexion (319) qui se trouve sur la seconde couche de silicium (313-318) avec interposition d'une couche d'isolation de grille (353).

6. Le circuit intégré à semiconducteurs selon la revendication 5, caractérisé en ce que la couche isolante (352) entre la première couche de silicium (308-312) et la seconde couche de silicium (313-318) est plus épaisse que la couche d'isolation de grille (353) entre la première couche d'interconnexion (319) et la seconde couche de silicium.

7. Le circuit intégré à semiconducteurs selon l'une quelconque des revendications précédentes, caractérisé en ce que la première couche de silicium (108-112 ; 308-312) est formée sur l'électrode de grille (106, 107 ; 306, 307) du transistor MIS d'attaque (Q1, Q2), avec interposition d'une couche d'isolation de grille (151 ; 351).

8. Le circuit intégré à semiconducteurs selon la revendication 7, caractérisé en ce que le dispositif de charge est constitué par un transistor MIS de charge, ayant pour canal une région locale (109, 110 ; 309, 310) de la première couche de silicium qui se trouve sur l'électrode de grille du transistor MIS d'attaque.

9. Le circuit intégré à semiconducteurs selon la revendication 8, caractérisé en ce que le transistor MIS de charge et le transistor MIS d'attaque se partagent la même électrode de grille (106, 107 ; 306, 307).

10. Le circuit intégré à semiconducteurs selon la revendication 9, caractérisé en ce que la couche isolante (151 ; 351) entre l'électrode de grille (106, 107 ; 306, 307) du transistor MIS d'attaque (Q1, Q2) et le transistor MIS de charge (R1, R2) est plus mince que la couche isolante (152 ; 352) entre la première couche de silicium et la seconde couche de silicium.

11. Le circuit intégré à semiconducteurs selon la revendication 9, caractérisé en ce que l'électrode de grille du transistor MIS de transfert (Q3, Q4) est formée par une troisième couche de silicium (113) qui se trouve entre les première et seconde couches de silicium, une couche isolante (152) entre les première et troisième couches de silicium étant plus épaisse que la couche d'isolation de grille (151) entre la première couche de silicium et l'électrode de grille (106, 107) des transistors MIS d'attaque et de charge, et plus épaisse que la couche d'isolation de grille (153) entre les seconde et troisième couches de silicium.

12. Le circuit intégré à semiconducteurs selon l'une quelconque des revendications précédentes, caractérisé en ce que la couche isolante (152 ; 352) entre les première et seconde couches de silicium (108-112, 114-119 ; 308-312, 313-318) est constituée par de l'oxyde de silicium qui ne contient presque aucune impureté.

13. Le circuit intégré à semiconducteurs selon la revendication 11, caractérisé en ce que la couche isolante (152) entre les première et troisième couches de silicium est formée par de l'oxyde de silicium qui ne contient presque aucune impureté.

14. Le circuit intégré à semiconducteurs selon la revendication 8, caractérisé en ce que la première couche de silicium comporte une région locale (108 ; 308) qui forme le drain du transistor MIS de charge (R1, R2), et qui est connectée électriquement à une région de diffusion de drain (101, 102 ; 301, 302) du transistor MIS d'attaque (Q1, Q2), par l'intermédiaire d'un premier trou de contact (134, 135 ; 334, 335), et en ce que la seconde couche de silicium comporte une région locale (114, 115 ; 313, 314) qui forme un drain ou une source du transistor MIS de transfert (Q3, Q4) et qui est connectée électriquement à la première couche de silicium par l'intermédiaire d'un second trou de contact (136, 137 ; 336, 337).

15. Le circuit intégré à semiconducteurs selon l'une quelconque des revendications précédentes, caractérisé en ce que la ligne de données (BL, B̅L̅) est en contact avec la seconde couche de silicium, et un troisième trou de contact (138, 139 ; 338, 339) est formé au-dessus d'une partie d'une région de diffusion de source du transistor MIS d'attaque.

16. Le circuit intégré à semiconducteurs selon la revendication 15, caractérisé en ce que le troisième trou de contact (138, 139 ; 338, 339) est formé au-dessus d'une partie de la première couche de silicium (118, 119 ; 317, 318).

17. Le circuit intégré à semiconducteurs selon l'une quelconque des revendications 8 à 16, caractérisé en ce que le transistor MIS d'attaque est du type N et le transistor MIS de charge est du type P.

18. Le circuit intégré à semiconducteurs selon l'une quelconque des revendications précédentes, caractérisé par un second inverseur formé de la même manière que le premier inverseur, dans une région adjacente au premier inverseur, les deux inverseurs formant un circuit bistable.

19. Le circuit intégré à semiconducteurs selon la revendication 18, caractérisé en ce que le circuit bistable forme une cellule d'une mémoire vive statique (ou SRAM).

20. Le circuit intégré à semiconducteurs selon la revendication 19, caractérisé en ce qu'une interconnexion de la paire de lignes de données (BL, B̅L̅) est formée sur les transistors MIS de transfert (Q3, Q4) avec interposition d'une couche isolante (154, 354) dont au moins la partie qui vient en contact avec les canaux des transistors MIS de transfert (Q3, Q4) est plus épaisse que la couche d'isolation de grille (153, 353) dans les transistors MIS de transfert (Q3, Q4).

21. Le circuit intégré à semiconducteurs selon les revendications 8 et 20, caractérisé en ce que les couches isolantes qui viennent en contact avec au moins une partie des canaux des transistors MIS dee charge (R1, R2) ou des transistors MIS de transfert (Q3, Q4) sont constituées par de l'oxyde de silicium qui est presque exempt d'impuretés.

22. Le circuit intégré à semiconducteurs selon l'une quelconque des revendications 19 à 21, caractérisé en ce que les transistors MIS d'attaque (Q1, Q2) et les transistors MIS de transfert (Q3, Q4) sont d'un premier type de conductivité et les transistors MIS de charge (R1, R2) sont d'un second type de conductivité, différent du premier type de conductivité.

23. Le circuit intégré à semiconducteurs selon l'une quelconque des revendications 19 à 21, caractérisé en ce que les transistors MIS d'attaque (Q1, Q2) sont d'un premier type de conductivité et les transistors MIS de transfert (Q3, Q4) et les transistors MIS de charge (R1, R2) sont d'un second type de conductivité, différent du premier type de conductivité.

24. Le circuit intégré à semiconducteurs selon la revendication 22 ou 23, caractérisé en ce que le premier type de conductivité est le type N et le second type de conductivité est le type P.

25. Le circuit intégré à semiconducteurs selon l'une quelconque des revendications précédentes, caractérisé en ce que le substrat semiconducteur (300) est un substrat en silicium monocristallin et les couches minces de semiconducteur sont des couches minces de silicium polycristallin ou monocristallin.
